# EUROPEAN PATENT SPECIFICATION

(11) **EP 1 848 790 B1**
(45) Date of publication and mention of the grant of the patent: **08.04.2015**
(21) Application number: 06734759.1
(22) Date of filing: 13.02.2006
(51) Int. Cl.: C11D 11/00

(54) **SEMICONDUCTOR CLEANING**
HALBLEITERREINIGUNG
NETTOYAGE D'UN SEMI-CONDUCTEUR

(30) Priority: 14.02.2005 US 651998 P; 30.12.2005 US 754605 P; 10.02.2006 US 350757; 10.02.2006 US 350758
(43) Date of publication of application: 31.10.2007
(73) Proprietor: Advanced Process Technologies, LLC., Tucson, AZ 85730 (US)
(72) Inventor: SMALL, Robert J., Tucson, AZ 85747 (US)
(74) Representative: Moreland, David
(86) International application number: PCT/US2006/004774
(87) International publication number: WO 2006/088737

(56) References cited:
- WO-A1-02/086045
- JP-A- 2004 285 354
- KR-A- 20010 058 668
- US-A1- 2001 056 052
- US-B1- 6 379 634
- US-B1- 6 624 127

## Description

### FIELD OF THE INVENTION

The invention relates to the cleaning of surfaces of substrates. In particular, the invention relates to the cleaning of the surfaces of semiconductor substrates.

### BACKGROUND OF THE INVENTION

As semiconductor device sizes move toward the submicron regime, the challenges associated with particulate microcontamination present substantial hurdles to success. Advances in semiconductor processing are needed to ensure that manufacturing efficiencies can be kept high. In particular, improved performance-at-yield and significant increases in wafer throughput (e.g., more than 160 of 200 mm wafers/hr) are desired to reduce unit costs. The emerging applications for nanotechnologies also require special cleaning, and new deposition methods and materials will be required. In an industry driven by device yield, reliability, and performance criteria, substrate cleaning has become particularly important for efficiency and profitability.

Processing of advanced semiconductor materials, e.g., plasma etching, deposition, or chemical mechanical polishing, can leave residues (particle, ionic, or both) that are difficult to remove with conventional cleaning processes (such as wet benches, spray tools, etc). Critical residue particle sizes continue to decrease to below 20 nm, yet conventional particle removal methods (spray, ultrasonic, and megasonics) are ineffective, will damage the desired submicron structural features, or both.

As submicron processing advances, it becomes important to remove or neutralize etching residue and photoresist from the substrate, for example so that the residues do not absorb moisture and form acidic species that can cause undesired metal corrosion. If such metal residues are not removed, the substrate's devices may short. In addition, plasma etching of metals, for example, results in a variety of residues, and presents the challenge of adequately cleaning surface(s) of a substrate without corroding the metal.

Moreover, there is a thrust within the semiconductor industry to significantly reduce chemical and water consumption for both cost control and environmental concerns. Water consumption has been a growing concern in both the US and European markets. Although the industry is adapting cleaning chemistries with higher water content, the overall requirements are for semiconductor facilities to reduce total water consumption. Some alternative technologies contemplated for use are based on supercritical CO₂ with co-solvents, cryogenics, plasma, laser shock, ion beam, or UV/ozone processes.

Despite the work done, for example, with supercritical CO₂, laser shock waves, and UV ozone, each of these technologies has experienced significant technical barriers. Supercritical CO₂ currently requires the use of co-solvents and controlled rinse sequences at pressures up to 3,000 psi. Yet, the goals of elimination of secondary deposition of particles and reduction of cycle times below 5 minutes have not been achieved. For example, laser shock (the convergence of two laser beams at some distance from the wafer surface) can easily damage wafer surfaces and carries the additional requirement that the wafer be processed through a traditional wet cleaning step in order to be able to remove ionic contamination. The UV ozone process is designed to generate high-energy free radical species to scavenge organic residues, but remains largely unproven for mainstream application.

U.S. Patent No. 6,624,127 to Brask et al. is directed to the removal of residues from semiconductor structures and discloses a composition that includes supercritical carbon dioxide and may further include an ionic liquid. Further, JP 2004 285354 to Ishikawa et al. is directed to a cleaning composition and discloses a composition that is a detergent comprising an organic onium cation, an organic onium salt, and an organic solvent. Moreover, WO 02/086045 A1 to Naghshineh discloses a cleaning composition that comprises an alkanolamine, a tetraalkylammonium hydroxide, a nonmetallic fluoride salt, a corrosion inhibitor, or an ascorbic acid or its derivatives. In addition, U.S. Patent Application Publication No. US 2001/056052 A1 to Aoki et al. discloses a cleaning liquid that comprises an organic alkaline amine compound and hydrogen peroxide. Also, KR 2001 0058668 A to Ha Sang Rok et al. is directed to a cleansing solution containing a fluoride based compound, and discloses a cleansing solution that comprises a mixture of an electrolytic ionic liquid and fluoride based compound containing 0.01-50 wt.% HF or NH4.

During the late 1980's, combined government/industry programs were started to develop semiconductor fabrication processes that required few or no liquid chemical processing steps. The programs were not able to achieve these goals though they were able to further establish the benefits of plasma etch over wet etch of integrated circuit (IC) features. Newer technologies have been contemplated to minimize the cleaning challenges and include direct-imageable materials and in-situ/in-step post processing. The semiconductor industry continues to support research in this direction (see, e.g., Solid State Technology, Mar. 1999, S13; Semiconductor Online, Mar. 2, 1999). However, incomplete removal of ionic species and particle contamination continue to be pressing issues. Various matured technologies for the production of a clean and dry 90 nm node copper semiconductor wafer with ultra low-k dielectrics, for example, have failed to meet expectations (according to the ITRS 2002).

Attempts have been made with current plasma etch equipment to program, design or adjust process parameters to minimize or eliminate post-etch residues, but because of the newer materials (cobalt silicides, Cu, low-k materials, HfO₂, ZrO₂, Pt, Ru, etc.) and the increasing aspect ratios and reduced particle sizes, these efforts have not met the current cleaning requirements. Conventional wet chemical cleaning methods also have not been able to meet some of these requirements.

Mist deposition of films on substrates also is known. See P. Mumbauer et al., Mist Deposition in Semiconductor Device Manufacturing, Semiconductor International, dated November 1, 2004.

High throughput semiconductor cleaning processes are needed for providing high particle removal efficiency (PRE) while minimizing damage or undesired etching. *See* Steven Verhaverbeke (Applied Materials), "An Investigation of the Critical Parameters of a Atomized, Accelerated Liquid Spray to Remove Particle," presented at the 208th Meeting of the Electrochemical Society, Los Angeles, California, October 16-21, 2005, symposium on Cleaning Technology in Semiconductor Device Manufacturing IX, Electronics and Photonics/Dielectric Science and Technology; *see also* Ken-Ichi Sano et al. (Dainippon Screen and IMEC), "Single Wafer Wet Cleaning for a High Particle Removal Efficiency on Hydrophobic Surface," also presented at the 208th Meeting of the Electrochemical Society. Verhaverbeke reported the use of atomized, accelerated liquid sprays to remove particles in which the gas velocities used to accelerate the liquid droplets approached 50 m/s. Sano *et al.* reported the use of a two-step single wafer cleaning process.

Conventional spray cleaning processes typically employ nozzles disposed between about 45° and about 90° with respect to the wafer surface. Conventional cryogenic cleaning processes typically employ nozzles disposed between about 75° and about 90° with respect to the wafer surface. High speed wet cleaning has been limited below 100 m/s, thus well below supersonic speeds (about 360 m/s).

In view of these developments, there is a need for chemistry that can be used in the reaction/removal of contaminants on a substrate. There further is a need for chemistry that may encapsulate particles. Moreover, there is a need for chemistry that permits acceptable drying of a substrate after application. Also, there is a need for chemistry that may remove substantially all trace residuals to below 4 nm detection levels at less than 50 ppb without damage or impounding of contaminants into the substrate. In addition, there is a need for methods and apparatus for delivering the chemistry in a precisely controlled fashion. And, there is a need for processing with reduced water and chemical consumption as compared to the mainstream technologies of the prior art. There additionally is a need for such processing at atmospheric or near-atmospheric conditions instead of the high vacuum conditions required by prior art processes.

### SUMMARY OF THE INVENTION

The wet chemistries of the present invention, for example, may be used in stripping photoresists and cleaning organic and inorganic compounds, including post etch and post ash residues, from a semiconductor substrate.

In one aspect, the present invention relates to a method of cleaning submicron features on a semiconductor substrate that includes contacting a surface of the semiconductor substrate with a composition comprising an ionic liquid in neat or substantially pure form, wherein the ionic liquid comprises one or more cations and one or more anions. The ionic liquid can include a cation selected from the group consisting of an imidazolium cation, a pyridinium cation, a pyrrolidinium cation, an ammonium cation, and a phosphonium cation.

In one exemplary embodiment, the ionic liquid can include a cation having the formula: 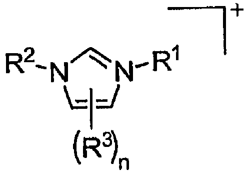 wherein R¹ is an optionally substituted C₁-C₂₀ alkyl, cycloalkyl, aralkyl, alkenyl, cycloalkenyl, or alkynyl group; R² is hydrogen or an optionally substituted C₁-C₂₀ alkyl, cycloalkyl, aralkyl, alkenyl, cycloalkenyl, or alkynyl group and R³ is an optionally substituted C₁-C₁₂ alkyl, cycloalkyl, aralkyl, alkenyl, cycloalkenyl, or alkynyl group; and n is 0, 1, 2 or 3.

In another exemplary embodiment, the ionic liquid can include a cation having the formula: 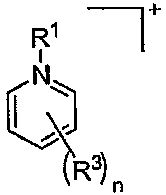 wherein R¹ is an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3.

In another exemplary embodiment, the ionic liquid can include a cation having the formula: 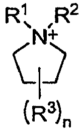 wherein R¹ and R², independently, are each an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3.

In another exemplary embodiment, the ionic liquid can include a cation having the formula: 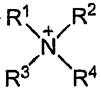 wherein R¹, R², R³, and R⁴, independently, are each an optionally substituted C₁-C₂₀ alkyl, cycloalkyl, aralkyl, alkenyl, cycloalkenyl, or alkynyl group.

In another exemplary embodiment, the ionic liquid can include a cation having the formula: 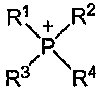 wherein R¹, R², R³, and R⁴, independently, are each an optionally substituted C₁-C₂₀ alkyl, cycloalkyl, aralkyl, alkenyl, cycloalkenyl, or alkynyl group.

In some exemplary embodiments, the ionic liquid can include a cation selected from the group consisting of a 1,3-dialkylimidazolium cation, a 1-alkylpyridinium cation, an N,N-dialkylpyrrolidinium cation, an tetraalkylammonium cation, and a tetraalkyl phosphonium cation.

In some exemplary embodiments, the ionic liquid can include a eutectic mixture. The eutectic mixture can include a quaternary ammonium salt and a hydrogen bonding partner.

The quaternary ammonium salt can include a cation having the formula: 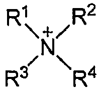 wherein R¹, R², R³, and R⁴, independently, are each an optionally substituted C₁-C₂₀ alkyl, cycloalkyl, aralkyl, alkenyl, cycloalkenyl, or alkynyl group.

The quaternary ammonium salt can include a halide ion. The quaternary ammonium salt can be choline chloride. The hydrogen bonding partner can include a carboxylic acid, an amide, or a urea.

The hydrogen bonding partner can include a compound having the formula: 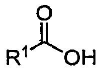 wherein R¹ is an optionally substituted C₁-C₂₀ alkyl, cycloalkyl, aralkyl, alkenyl, cycloalkenyl, or alkynyl group; or an optionally substituted C₁-C₁₀ aryl or heteroaryl group.

The hydrogen bonding partner can include a compound having the formula: 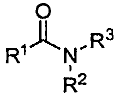 wherein R¹ is an optionally substituted C₁-C₂₀ alkyl, cycloalkyl, aralkyl, alkenyl, cycloalkenyl, or alkynyl group; or an optionally substituted C₁-C₁₀ aryl or heteroaryl group; and R² and R³, independently, are each hydrogen or an optionally substituted C₁-C₂₀ alkyl, cycloalkyl, aralkyl, alkenyl, cycloalkenyl, or alkynyl group.

The hydrogen bonding partner can include a compound having the formula: 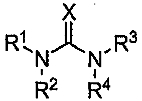 wherein X is O or S; and each of R¹, R², R³, and R⁴, independently, is an optionally substituted C₁-C₂₀ alkyl, cycloalkyl, aralkyl, alkenyl, cycloalkenyl, or alkynyl group; or an optionally substituted C₁-C₁₀ aryl or heteroaryl group.

In some exemplary embodiments, the surface can be contacted with the composition for a period of time ranging from 30 seconds to 30 minutes; 30 seconds to 2 minutes; or from 2 minutes to 30 minutes. In some exemplary embodiments, the surface can be contacted with the composition at a temperature between 20°C and 70 °C; 20 °C and 50 °C; or 20 °C and 35 °C.

The method can include rinsing the semiconductor substrate with water after contacting the semiconductor substrate with the composition. The method can include rinsing the semiconductor substrate with a solvent prior to rinsing the semiconductor substrate with water.

In some exemplary embodiments, the ionic liquid can be discharged toward the semiconductor substrate through at least one nozzle oriented at an angle between about 0 ° and about 45 ° with respect to the surface or oriented at an angle between about 0 ° and about 25 ° with respect to the surface. In one exemplary embodiment, the ionic liquid can be discharged toward the semiconductor substrate through at least one nozzle oriented at an angle no more than about 5° transverse to the surface.

In another aspect, the invention relates to a substrate cleaned according to the above-described methods, with the semiconductor substrate being a wafer in some embodiments.

A method of cleaning a substrate that includes contacting a surface of a semiconductor substrate with a composition comprising a superacid is also described. The superacid can include a mixture of FSO₃H, SbF₅, and SO₂; a mixture of HF and BF₃; or a mixture of SbF₅ and HF. The semiconductor substrate can include a photoresist. The surface can be contacted with the composition for a period of time ranging from 30 seconds to 30 minutes; 30 seconds to 2 minutes; or from 2 minutes to 30 minutes. The surface can be contacted with the composition at a temperature between 20 °C and 70 °C; 20 °C and 50 °C; or 20 °C and 35 °C. The superacid can be discharged toward the semiconductor substrate through at least one nozzle oriented at an angle between about 0° and about 45 ° with respect to the surface or oriented at an angle between about 0° and about 25° with respect to the surface. The superacid can be discharged toward the semiconductor substrate through at least one nozzle oriented at an angle no more than about 5° transverse to the surface. A substrate cleaned according to this method is also described, with the semiconductor substrate being a wafer.

In another aspect of the invention, a method of removing undesired material from a semiconductor wafer includes contacting the semiconductor wafer with a composition comprising an ionic liquid at a temperature and for a time sufficient to dislodge residue therefrom.

A method of removing undesired material from a semiconductor wafer comprises contacting the semiconductor wafer with a composition comprising a superacid at a temperature and for a time sufficient to dislodge residue therefrom is also described.

A method of removing undesired material from a semiconductor wafer comprising contacting the semiconductor wafer with a composition comprising a superacid at a temperature and for a time sufficient to strip photoresist therefrom is also described.

An integrated circuit fabrication process including: etching a semiconductor layer on a wafer; applying a superacid to the wafer to remove residues from the etching; rinsing the wafer with water is also described.

In addition, the invention relates to a process for removing residue from an integrated circuit, which includes contacting the integrated circuit with a composition comprising an ionic liquid at a temperature and for a time sufficient to remove the residue from the integrated circuit.

And, a process for removing residue from an integrated circuit, which includes contacting the integrated circuit with a composition comprising a superacid at a temperature and for a time sufficient to remove the residue from the integrated circuit is described.

The present invention further relates to a method of modifying a surface, the method including: directing a plurality of nano-clusters toward the surface in generally atmospheric conditions; impacting the nano-clusters proximate the surface. In some embodiments, the nano-clusters may include propylene carbonate or TMAH. Also, in some embodiments the nano-clusters include an ionic liquid and an oxidizer. The ionic liquid and oxidizer may be mixed just prior to directing the nano-clusters toward the surface. The method may further include: permitting the nano-clusters to decompose within between about 10 minutes and about 1 second of contacting the surface. The nano-clusters may impact the surface in a positive pressure atmosphere. Each nano- cluster may have a size between about 4 nm and about 12 nm before impacting proximate the surface. Also, the nano-clusters may be directed toward the surface in the form of a plasma. The method may further include: breaking apart the nano-clusters proximate the surface; and encapsulating a particle initially disposed on the surface in the broken apart nano-clusters.

### DETAILED DESCRIPTION OF THE PREFERRED EMBODIMENTS

In an exemplary preferred embodiment of the present invention, a liquid composition is contacted with a surface to remove undesired material from the surface. Undesired material can be any material that interferes with the ultimate function of the surface. When the surface includes a semiconductor substrate (e.g., a wafer), undesired material can include, for example, resist residues or metal ions. The composition can be useful in applications such as coating, plating, imaging, surfacing, processing, cleaning and sterilization. In some embodiments, the liquid composition includes an aqueous chemistry. Although the present invention is readily applicable to the semiconductor industry (e.g., for submicron cleaning of wafers), it is not limited to use with any particular industry and instead may be applied in a wide variety of technology areas requiring the removal of contaminants to a very fine scale (e.g., nearly to the molecular level).

In an exemplary preferred embodiment of the present invention, a substrate in the form of a semiconductor wafer may have undesired material on surface(s) thereof such as post etch residue from aluminum- or copper-based technologies. The wafer can be contacted with a desired chemistry, for example, by immersion on a wet bench, e.g. a wet bench manufactured by Semitool or Tokyo Electron (TEL), or by a spray tool. The spray tool, for example, may be obtained from SEZ or Dainippon Screen Manufacturing Co. Ltd. (DNS) and the spray tool may be a single wafer spray tool. The process time, which depends on the equipment used, can be between 30 seconds and 30 minutes, such as for example, between 30 seconds and 2 minutes, or between 2 minutes and 30 minutes. The process temperature can be between 20°C and 70°C, preferably between 20°C and 50°C, or more preferably between 20°C and 35°C. After cleaning, the wafer may be rinsed, either with water, or first with a solvent such as an organic solvent N-methylpyrrolidone (NMP), isopropyl alcohol (IPA), or dimethyl sulfoxide (DMSO), followed by a final rinse with water.

In one exemplary method according to the present invention, the following steps maybe employed: etching, ashing and/or application of wet chemistry to remove photoresist and/or etch residues; rinse with carbonated water, NMP, IPA, or DMSO to remove and/or neutralize debris and remaining wet chemistry from the etched surface; and finally a deionized (DI) water rinse.

Preferably the wet chemistry can be captured after use and used again in additional cleaning cycles. The chemistry can be reused until the level of impurities in the chemistry exceeds a predetermined level.

Nano-clusters of the chemistry may be formed and charged with atmospheric inert gases in the liquid flow. The nano-clusters may expand and then impinge on a substrate surface, removing surface particles that may be larger than the nano-clusters themselves, in some embodiments, particles ranging from about 5 microns to less than about 4 nm may be removed from a substrate. In some exemplary embodiments, the clusters may travel at super-sonic speeds.

In general, the wet chemistry may be a composition that includes a solvent and optionally one or more additional components mixed with or dissolved in the solvent. The solvent can be, for example, a halogenated solvent, an aprotic solvent, a protic solvent, an organic acid, an alkanolamine, an alcohol, an amide, an ester, a dipolar aprotic solvent, an ether, a quaternary amine, a cyclic amine, a perfluorinated compound, an aliphatic ester, an inorganic acid, or an inorganic base. Exemplary solvents of these classes are listed in Table 1. The solvent can include an ionic liquid. The solvent can include a mixture of solvents, such as, for example, a mixture of a polar solvent with a protic solvent, a mixture of two distinct protic solvents, or a mixture of a polar solvent with an ionic liquid. The composition can include a superacid. The ionic liquid is used in a neat or substantially pure form. In other words, the ionic liquid can be used for substrate cleaning without adding any additional materials to the ionic liquid. A superacid can be diluted before use, for example, in the range of 2- 10% by weight.

**Table 1**

| Name | Solvent Class | Molecular Formula | CAS # | B.P. | Fr. P. | Flash P. | Density | Surface Tension dynes/cm | Dielectric Constant | Viscosity cp |
|---|---|---|---|---|---|---|---|---|---|---|
| Chloroform | Halogenated solvent | CHCl3 | 67-66-3 | 61 | -64 | na | 1.493 | 27.5 | 4.81 | 0.58 |
| Formamide | Aprotic solvent | CH3NO | 75-12-7 | 210.5 | 2.6 | 154 | 1.133 | 57.6 | 84 | 1.4 |
| N-Methyl formamide | Aprotic solvent | C2H4NO | 123-39-7 | 182.5 | -3.8 | 98 | 1.018 | | 182.4 | 1.7 |
| Acetic acid | Organic acid | C2H4O2 | 64-19-7 | 117.9 | 16.7 | 40 | 1.044 | 27.4 | 6.15 | 1.13 |
| Acetonitile | Aprotic solvent | C2H3N | 75-05-8 | 81 | -47 | 5 | 0.786 | 28.9 | 37.5 | 0.345 |
| 1,2 Dichloro ethane | Halogenated solvent | C2H4CI2 | 107-06-2 | 83 | -35 | 15 | 1.256 | 33.3 | 10.4 | 0.74 |
| Glycolic acid | Organic acid | C2H4O3 | 79-14-1 | 112 | 10 | na | 1.27 | | ~30 | 11.3 |
| 2-Aminoethanol | Alkanolamine | C2H7NO | 141-43-5 | 169 | 10 | 93 | 1.013 | 48.9 | 37.7 | |
| Dimethyl sulfoxide | Aprotic solvent | C2H6SO | 67-68-5 | 189 | 18.5 | 95 | 1.095 | 43 | 46.7 | 1.99 |
| Ethylene Carbonate | Polar solvent | C3H403 | 96-49-1 | 238 | 36.4 | 160 | 1.32 | 43.9 | 89.6 | 0.99 |
| Acetone | Aprotic solvent | C3H60 | 67-64-1 | 56.2 | -95.4 | <-20 | 0.79 | 25.2 | 20.7 | 0.32 |
| Isopropyl alcohol | Alcohol | C3H70 | 67-63-0 | 82.4 | -88 | 12 | 0.79 | 23 | 19.9 | 2.43 |
| N,N Dimethyl formamide | Amide | C3H7NO | 68-12-2 | 152 | -61 | 57 | 0.946 | 35.2 | 36.7 | 0.8 |
| g-Butyrolactone | Ester | C4H602 | 96-48-0 | 204 | 143. | 98.3 | 1.125 | 40.4 | 39 | 1.73 |
| Propylene carbonate | Polar solvent | C4H703 | 108-32-7 | 242 | -49 | 135 | 1.2 | 40.9 | 64 | 2.5 |
| Methyl ethyl ketone | Aprotic solvent | C4H8O | 78-93-3 | 79.6 | -86.7 | -3 | 0.805 | 24.6 | 18.5 | |
| Butyric acid | Organic acid | C4H802 | 107-92-6 | 163.3 | -5.2 | 76 | 0.96 | 26.8 | 2.97 | 1.53 |
| Sulfolane | Dipolar aprotic solvent | C4H802S | 126-33-0 | 287.3 | 28.5 | 166 | 1.26 | 50.9 | 43.3 | 11.6 |
| N,N Dimethyl acetamide | Amide | C4H9NO | 127-19-5 | 165 | -20 | 70 | 0.938 | 33.5 | 37.8 | 0.93 |
| Propylene Glycol Me ether | Ether | C4H10O2 | 111-77-3 | 120 | -97 | 31 | 0.921 | 27.7 | | 1.7 |
| Digylcolamine (DGA) | Alkanolamine | C4H11NO2 | 929-06-6 | 221 | 111 | 127 | 1.053 | 44.4 | | 26.2 |
| TMAH (25%) | Quaternary amine | C4H13NO | 75-59-2 | 100 | <-25 | >200 | 1.016 | | | 2.8 |
| N-Methylpyrrolidone | Amide | C5H9NO | 872-50-4 | 202 | -24.4 | 86 | 1.028 | 40.1 | 32 | 1.65 |
| Morpholine | Cyclic amine | C5H11N | 110-91-8 | 129 | -7 | 35.5 | 0.995 | 36.9 | 7.42 | 2.04 |
| 1,5 Pentanediol | Alcohol | C5H1202 | 111-29-5 | 242 | -16 | 129 | 0.992 | 43.3 | 26.2 | |
| Vertrel XF | perfluorinated cmpd | C5H2F10 | | 55 | | na | 1.58 | 14-19 | 7-10 | 0.67 |
| Lactic acid, Butyl ester | Aliphatic ester | C7H1403 | 138-22-7 | 186 | -43 | 79 | 0.98 | 28 | 5.1 | 3.22 |
| Dipropylene glycol Me ether | Ether | C7H1503 | 34590-94-8 | 190 | -83 | 75 | 0.953 | 28.8 | | 3.7 |
| Sulfuric acid | Inorganic acid | H2SO4 | 7664-93-9 | 327 | -2 | na | 1.84 | 73.5 | 100 | 21.2 |
| Hydroxylamine | Inorganic base | NH30 | 7803-49-8 | 107 | 7 | na | 1.12 | | | |
| Water | Polar solvent | H2O | 7732-18-5 | 100 | 0 | na | 1 | 72.8 | 78.5 | 0.9 |

Ionic liquids can have advantageous environmental properties over other solvents. Ionic liquids are substantially non-volatile. Some ionic liquids are biodegradable. Ionic liquids can be less toxic than other solvents, or even non-toxic.

In some circumstances, organic photoresist polymers become at least partially carbonized after the substrate is subjected to an ion implant step. The at least partially carbonized photoresist can be difficult to remove, but failing to remove it may interfere with further substrate processing. Superacids may be used to remove such photoresists from a substrate.

Thus, discussed next are ionic liquids for use as the wet chemistry for substrate cleaning in accordance with the present invention.

An ionic liquid includes cations (positively charged species) and anions (negatively charged species), and has a melting point at or below 100°C. For example, an ionic liquid can include an organic cation such as a 1,3-dialkylimidazolium, a 1- alkylpyridinium, an N,N-dialkylpyrrolidiniurn, an ammonium, or a phosphonium cation. A wide range of anions can be employed, such as, for example, a halide (e.g., chloride), an inorganic anion (e.g., tetrafluoroborate or hexafluorophosphate), or an organic anion (e.g., bis-trifluorsulfonimide, triflate, or tosylate). As one example, the melting point of 1-butyl-3-methylimidazolium tetrafluoroborate is about -71 °C; this compound is a colorless liquid with high viscosity at room temperature. Additional exemplary ionic liquids are listed in Table 2.

**Table 2: Exemplary Ionic Liquids**

| |
|---|
| 1-ethyl-3-methylimidazolium methanesulfonate |
| methyl-tri-n-butyl ammonium methylsulfonate |
| 1-ethyl-2,3-dimethylimidazolium ethylsulfonate |
| 1-butyl-3-methylimidazolium ethylsulfate |
| 1-butyl-3-methylimidazolium methanesulfonate |
| 1-ethyl-3-methylimidazolium chloride |
| 1,2,3-trimethylimidazolium methylsulfate |
| 1-butyl-3-methylimidazolium tetrachloroaluminate |
| 1-ethyl-3-methylimidazolium tetrachloroaluminate |
| 1-ethyl-3-methylimidazolium hydrogensulfonate |
| 1-butyl-3-methylimidazolium hydrogensulfonate |
| methylimidazolium hydrogensulfonate |
| methylimidazolium chloride |
| 1-ethyl-3-methylimidazolium acetate |
| 1-butyl-3-methylimidazolium acetate |
| 1-ethyl-3-methylimidazolium ethylsulfate |
| 1-butyl-3-methylimidazolium methylsulfate |
| 1-ethyl-3-methylimidazolium thiocyanate |
| 1-butyl-3-methylimidazolium thiocyanate |
| 1-butyl-3-methylimidazolium chloride |
| 1-butyl-3-methylimidazolium hexafluorophosphate |
| 1-ethyl-3-methylimidazolium tetrafluoroborate |
| 1-butyl-3-methylimidazolium tetrafluoroborate |
| 1-butyl-2,3-dimethylimidazolium chloride |
| 1-methyl-3-octylimidazolium trifluoromethanesulfonate 1-hexyl-3-methylimidazolium trifluoromethanesulfonate |
| 1-hexyl-3-methylimidazolium tetrafluoroborate |
| 1-methyl-3-octylimidazolium hexafluorophosphate |

Advantageously, ionic liquids are often colorless, poorly coordinating, and have substantially no vapor pressure, and can effectively dissolve residues. High solubility of residues in ionic liquids allows process intensification. In other words, only low liquid volumes are required in the treatments, thereby permitting a substantial reduction in the amount of chemical required to produce the desired result. The reduced amount of chemical that is used makes ionic liquid-based cleaning an environmentally friendly substrate cleaning process.

Suitable cations for ionic liquids can include, for example, an imidazolium cation having the formula: 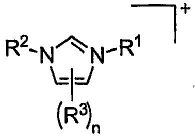 where R¹ is an optionally substituted C₁-C₂₀ alkyl, cycloalkyl, aralkyl, alkenyl, cycloalkenyl, or alkynyl group; R² is hydrogen or an optionally substituted C₁-C₂₀ alkyl, cycloalkyl, aralkyl, alkenyl, cycloalkenyl, or alkynyl group and R³ is an optionally substituted C₁-C₁₂ alkyl, cycloalkyl, aralkyl, alkenyl, cycloalkenyl, or alkynyl group; and n is 0, 1, 2 or 3. In some embodiments, R¹ can be C₁-C₆ alkyl and R² can be methyl. R¹ or R² can be optionally substituted by a polar or protic substituent, such as, for example, hydroxy. The pyrrolidinium cation can be an N,N-dialkylpyrrolidinium.

Another suitable cation is a pyridinium ion having the formula: 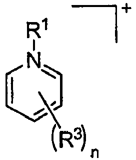 where R¹ is an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3. In some embodiments, R¹ can be C₁-C₈ alkyl. R³ can be C₁-C₆ alkyl. The pyridinium ion can be N-alkyl pyridinium ion.

Another suitable cation is a pyrrolidinium ion having the formula: 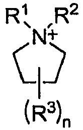 where R¹ and R², independently, are each an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3. In some embodiments, R¹ and R² are each independently C₁-C₆ alkyl. R¹ can be methyl and R² can be C₁-C₆ alkyl. The pyrrolidinium ion can be an N,N-dialkylpyrrolidinium ion.

Another suitable cation is an ammonium, such as a quaternary ammonium ion having the formula: 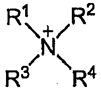 where R¹, R², R³, and R⁴, independently, are each an optionally substituted C₁-C₂₀ alkyl, cycloalkyl, aralkyl, alkenyl, cycloalkenyl, or alkynyl group. In some embodiments, R¹, R², R³, and R⁴, independently, are each C₁-C₈ alkyl. R¹ or R² can be optionally substituted by a polar or protic substituent, such as, for example, hydroxy. The ammonium ion can be a tetraalkylammonium ion.

Another suitable cation is a phosphonium ion having the formula: 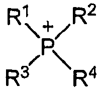 where R¹, R², R³, and R⁴, independently, are each an optionally substituted C₁-C₂₀ alkyl, cycloalkyl, aralkyl, alkenyl, cycloalkenyl, or alkynyl group. In some embodiments, R¹, R², R³, and R⁴, independently, are each C₁-C₈ alkyl. The phosphonium ion can be a tetraalkylphosphonium ion.

Suitable anions for an ionic liquid include a halide (e.g., fluoride, chloride, bromide, or iodide), a sulfate, a sulfonate, a carboxylate (e.g., acetate or propionate), a sulfonimide (e.g., bis(trifluoromethylsulfonyl)imide), a phosphinate (e.g., bis(2,4,4-trimethylpentyl)phosphinate), a phosphate (e.g., tris(pentafluoroethyl)trifluorophosphate) an inorganic anion (e.g., tetrafluoroborate, hexafluorophosphate, or tetrachloroaluminate), thiocyanate, or dicyanamide.

A sulfate can have the formula: 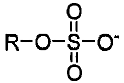 where R is C₁-C₂₀ alkyl, haloalkyl, cycloalkyl, aralkyl, alkenyl, cycloalkenyl, alkynyl, or aryl group. For example, R can be methyl, trifluoromethyl, p-tolyl, ethyl, n-butyl, n-hexyl, or n-octyl.

A sulfonate can have the formula: 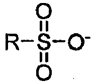 where R is C₁-C₂₀ alkyl, haloalkyl, cycloalkyl, aralkyl, alkenyl, cycloalkenyl, alkynyl, or aryl group. For example, R can be methyl, trifluoromethyl, p-tolyl, ethyl, n-butyl, n-hexyl, or n-octyl.

The ionic liquid can include a eutectic mixture. In general, a eutectic mixture is a mixture of two or more pure materials in a particular ratio that displays a reduced melting point compared to either material in a pure state. The eutectic mixture can be substantially free of metals ions. For example, the eutectic can be a mixture of organic compounds. The eutectic mixture can be a deep eutectic solvent. The eutectic mixture can be a mixture of a quaternary ammonium salt and a hydrogen-bonding partner. The quaternary ammonium salt also can be a halide salt, i.e., a salt of a quaternary ammonium ion and a halide ion, such as fluoride, chloride, bromide or iodide. The quaternary ammonium salt can be choline chloride. The hydrogen-bonding partner can be, for example, a carboxylic acid, an amide, or a urea. See, for example, Freemantle, M., Chem. Eng. News Sept. 12, 2005, 36-38; Abbott, A.P. et al., Chem. Comm. Jan. 7, 2003, 70-71; and Abbott, A.P. et al., J. Am. Chem. Soc. 2004, 126, 9142-9147, each of which is incorporated herein by reference in its entirety.

The quaternary ammonium salt can include a quaternary ammonium ion having the formula: 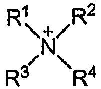 where R¹, R², R³, and R⁴, independently, are each an optionally substituted C₁-C₂₀ alkyl, cycloalkyl, aralkyl, alkenyl, cycloalkenyl, or alkynyl group. In some embodiments, R¹ is hydroxyl substituted C₁-C₈ alkyl, R², R³, and R⁴, independently, are each C₁-C₈ alkyl. R¹ can be hydroxyl substituted C₂ alkyl and R², R³ and R⁴ can each be methyl.

The hydrogen bonding partner can be a carboxylic acid having the formula: 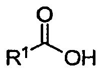 where R¹ is an optionally substituted C₁-C₂₀ alkyl, cycloalkyl, aralkyl, alkenyl, cycloalkenyl, or alkynyl group; or an optionally substituted C₁-C₁₀ aryl or heteroaryl group. The carboxylic acid can be selected from the group of adipic acid, benzoic acid, citric acid, malonic acid, oxalic acid, phenylacetic acid, phenylpropionic acid, succinic acid, and tricarballylic acid.

The hydrogen bonding partner can be an amide having the formula: 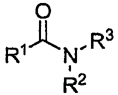 where R¹ is an optionally substituted C₁-C₂₀ alkyl, cycloalkyl, aralkyl, alkenyl, cycloalkenyl, or alkynyl group; or an optionally substituted C₁-C₁₀ aryl or heteroaryl group; and R² and R³, independently, are each hydrogen or an optionally substituted C₁-C₂₀ alkyl, cycloalkyl, aralkyl, alkenyl, cycloalkenyl, or alkynyl group.

The hydrogen bonding partner can be a urea having the formula: 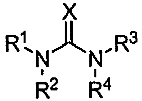 where X is O or S; and each of R¹, R², R³, and R⁴, independently, is an optionally substituted C₁-C₂₀ alkyl, cycloalkyl, aralkyl, alkenyl, cycloalkenyl, or alkynyl group; or an optionally substituted C₁-C₁₀ aryl or heteroaryl group.

The composition can include an acid. The acid can be a superacid, i.e., an acid with a greater proton-donating ability than 100% sulfuric acid. One well known example of a superacid is a mixture of FSO₃H-SbF₅-SO₂, sometimes referred to as "magic acid." Another superacid is a mixture of HF and BF₃. Still another is a mixture of SbF₅ and HF.

The chemistries can have a dielectric constant selected to support an electric charge. In a preferred, exemplary embodiment, the nano-clusters preferably are provided with sufficient velocity to mechanically dislodge surface particulate on substrates, while also chemically interacting with such particulate for example to lower surface adhesion. The nano-clusters can include an ionic liquid and an oxidizer that interact with a high pH material. Such a combination preferably has a short life before decomposing, such as trimethylphenylammonium hydroxide (TMPAH) or tetramethylammonium hydroxide (TMAH) combined with propylene carbonate. In an exemplary process, the ionic liquid and oxidizer may be mixed at the point-of-use, e.g., just prior to or during formation of nano-clusters. Such instantaneously-reactive removal chemistries are preferred for use with the methods described herein. The chemistries may be stable for about 1 hour or less prior to decomposition.The chemistries may be stable for about 1 minute or less prior to decomposition. The chemistries may be stable for 10 seconds or less prior to decomposition. The chemistries may be stable for 1 second or less.

A number of suitable ionic liquids are commercially available, for example, from Sigma-Aldrich (St. Louis, MO), or Merck KGaA (Darmstadt, Germany).

The composition can include a conductivity enhancing compound. The conductivity enhancing compound can include a preferably volatile salt. For example, an ammonium salt such as a ammonium acetate or ammonium carbonate may be used to impart conductivity to the liquid. Other suitable salts include non- volatile alkali metal salts such as NaI, KI, and CsI. Preferably, the concentration of salt in the liquid is about 0.1 normal to 2.0 normal.

The composition can include an oxidizer. The oxidizer can assist in the chemical removal of targeted material on the substrate surface. Preferably, the amount of oxidizer used to prepare the clusters is sufficient to assist the removal process, while being as low as possible to minimize handling, environmental, or similar or related issues, such as cost.

Hydroxylamine compounds, depending on pH, can be either an oxidizer or a reducing agent. The hydroxylamine compound can be an oxidizer. For example, the hydroxylamine compound can be hydroxylamine, a salt of hydroxylamine, a derivative of hydroxylamine, a salt of a derivative of hydroxylamine, or a combination thereof. The hydroxylamine compound may be organic or inorganic. Preferably, the hydroxylamine compound has formula: 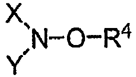 where R⁴ is hydrogen or a linear, branched, or cyclic C₁-C₇ hydrocarbon group; and where X and Y are, independently, hydrogen or a linear, branched, or cyclic C₁-C₇ hydrocarbon group, or wherein X and Y are linked together form a nitrogen-containing heterocyclic C₄-C₇ ring.

Examples of hydroxylamine compounds include hydroxylamine, N-methylhydroxylamine, N,N-dimethyl-hydroxylamine, N-ethyl-hydroxylamine, N,N-diethylhydroxylamine, methoxylamine, ethoxylamine, N-methyl-methoxylamine, and the like. Hydroxylamine and its derivatives, as defined above, are available as salts, e.g., sulfate salts, nitrate salts, phosphate salts, or the like, or a combination thereof.

The oxidizer can include an inorganic or organic per-compound. A per- compound is generally defined as a compound containing an element in its highest state of oxidation, such as perchloric acid; or a compound containing at least one peroxy group (-O-O-), such as peracetic acid and perchromic acid. Suitable per-compounds containing at least one peroxy group include, but are not limited to, urea hydrogen peroxide, a monopersulfate, a dipersulfate, peracetic acid, a percarbonate, and an organic peroxide, such as benzoyl peroxide or di-t-butyl peroxide. For example, ozone is a suitable oxidizer either alone or in combination with one or more other suitable oxidizers. The per- compound can be hydrogen peroxide.

Suitable per-compounds that do not contain a peroxy group include, but are not limited to, periodic acid, any periodiate salt, perchloric acid, any perchlorate salt, perbromic acid, and any perbromate salt, perboric acid, and any perborate salt.

Exemplary inorganic oxidizers include peroxymonosulfuric acid, potassium peroxymonosulfate, and ammonium peroxymonosulfate. Other oxidizers are also suitable; for example, iodates are useful oxidizers, and oxone is a useful oxidizer.

The oxidizer may be a salt of a metal having multiple oxidation states, a complex or coordination compound of a metal having multiple oxidation states, or any combination thereof, provided the compound has a sufficient oxidative potential to oxidize the substrate. Examples include permanganate or salts thereof and perchromate or salts thereof, iron salts, aluminum salts, cerium salts, and the like. When mixed with another common oxidizer such as hydrogen peroxide in a solution, the salts and oxidizer react and the oxidizing capacity of the mixture may decline with time. It is known that if the pH is above about 5, iron precipitates as Fe(OH)₃ and catalytically decomposes the hydrogen peroxide to oxygen. At a pH of below about 5, a solution of hydrogen peroxide and an iron catalyst is known as Fenton's reagent.

One disadvantage of metal-containing oxidizer salts is that they can leave metal contamination on the substrate. This metallic contamination can result in shorts and spurious conductive properties, along with other problems. Certain metals, such as those with a tendency to plate on or be absorbed on to at least one part of the substrate, may be more damaging than other metals. The total weight of the metal present in the liquid used to make the clusters may be less than 1 percent, less than 0.5 percent, less than 0.2 percent, less than 0.05 percent, less than 0.02 percent or less than 0.005 percent relative to the weight of the liquid. Clusters of the invention may be essentially free of metals, for example, completely free of metals. By essentially free of metals it is meant that the total weight of metal present in the liquid used to generate the clusters is less than 0.25 percent relative to the weight of the liquid.

Preferred solvents are listed in Table 1. An exemplary preferred solvent is propylene carbonate.

Residual removers for cleaning of semiconductors are known, for example, from U.S. Patent Application Publication No. 2004/0217006 A1

The wet chemistry may include one or more of the following: chelators, surfactants (nonionics, anionics, and/or cationics), abrasives, water, other solvents, corrosion inhibitors, basic amine compounds, acids and bases.

One exemplary method of cleaning a substrate using the cleaning compositions of the present invention comprises: contacting the substrate having residue thereon, e.g. organometallic or metal oxide residue, with a cleaning composition that includes an ionic liquid for a time and at a temperature sufficient to remove the residue. The substrate may be generally immersed in the cleaning composition.

In another exemplary method in accordance with the present invention, photoresist is stripped from a substrate using a method comprising: contacting the substrate having photoresist thereon with a composition that includes an ionic liquid for a time and at a temperature sufficient to remove the photoresist. The substrate may be generally immersed in the photoresist stripping composition.

In yet another exemplary method in accordance with the present invention, metal or oxide is etched in a method comprising: contacting the metal or oxide with an etching composition that includes an ionic liquid for a time and at a temperature sufficient to etch said metal or oxide. The metal or oxide may be generally immersed in the etching composition.

In some exemplary embodiments, the composition of the present invention can be selectively applied to the substrate, that is, applied to only to a predetermined region of the substrate. Selective application of the composition can be achieved, for example, by applying the composition with an ink jet printer.

In some exemplary embodiments of the present invention, chemistry may be delivered to a surface in the form of nano-clusters. The molecular structure of nano- clusters, as dispersed clouds with sizes between about 4 nm and about 12 nm, and in some embodiments preferably less than about 8 nm, provide a dry process environment for processing accuracy to atomic layer definition. In order to produce the nano-clusters and deliver them to the substrate, a nozzle may be used with sufficient charge at the nozzle via extractor electrodes. The resultant high-speed nano-clusters emitted under charge must then have the bonds broken down that hold the nano-clusters together. This may be accomplished with a mini discharge/dispersal field that completely eliminates charge, reduces the size of the nano-clusters for example from about 80 nm to between about 4 nm and about 12 nm (such as about 8 nm), and "aims" the nano-clusters. A plasma of nano-clusters may be created as a directed flow to the substrate without the physical size or force of the original nano-clusters.

In some embodiments, a clean cell preferably integrates with a gate interface and robotic handling mechanisms of a Semitool Mini-Raider platform. Also, in some embodiments, only one side of the wafer may be processed, while in other embodiments both sides are processed.

The clean cell, preferably formed of polyethylene therephthalate (PET), preferably has a positive pressure of purified atmosphere and/or inert gas (such as nitrogen) and has, as a means of withdrawing the contaminants, a side-flow evacuation system with upward-evacuation, and low vacuum withdrawal to plasmatic reclaim. The sub chamber (discharge/dispersal field), via the supersonic movement of nano-cluster plasma, may create a windmill effect that lifts the evacuant back to the vacuum or output port/reclaim above the surface interface. Redeposition may be avoided by the windmilling effect of the plasma directing the evacuants to the output port(s) and/or the use of common heavy gas laminar flow technology.

Preferably, the chamber supports atmospheric and positive-pressure gas environments, and the output port is either an evacuation for positive pressure atmospheric or gas atmosphere processing. In the low positive pressure gas environment, the gas is ionized to create the discharge and dispersal of the nano-clusters. Further, the gas may be blended to collect and evacuate the residual to a reclaim plasma filter for reuse of the gas. The array may be waferscale as a pattern of emitters angled toward evacuation port(s). This technique with a slowly revolving wafer (16-32 rpm) may produce higher throughputs above 200 Wph.

In some embodiments, a solvated atmospheric flow from a center point above the nozzle(s) to low-draw vacuum evacuation at the side(s) of the platen may add to encapsulation and suspension of the particles and residuals because the atmosphere is heavier and its flow can carry micro particles more thoroughly to the exhaust vacuum ports. In some embodiments, the solvated atmosphere may be ionized to more rapidly discharge the nano-clusters for dispersal using IR or UV ionizing methods. In some embodiments, subsonic or supersonic spray applications may rely on the momentum of small droplets without the need for ionization. The size, discharge and dispersal of the nano-clusters may be controlled by the height of the nozzle tip above the surface interface. Also, the nozzle preferably may have a conical tip like a blunderbuss so the nano-clusters have a broader spectrum or pattern array. And, the formulations of chemistry may be selected as a function of charge retention capabilities (e.g., dielectric constant) in addition to their reaction rates and surface effects for desired specific discharge and reaction. In a preferred exemplary embodiment the nozzle's patterns preferably overlap in a single row, "like lawn sprinklers" to keep the nano-clusters traveling toward the surface. A gap preferably may be provided row to row in order to allow the encapsulated particles and residuals to move out of the pattern and into the evacuation stream.

In some exemplary embodiments of the present invention, wet chemistry may be delivered to the substrate at an angle between about 0° and about 90°; between about 0° and about 45°; or between about 0° and about 25° with respect to the surface of the substrate. The wet chemistry may be delivered through nozzles that all are oriented at about the same angle with respect to the substrate or alternatively through nozzles oriented at a plurality of angles with respect to the substrate. Moreover, the wet chemistry may be delivered at speeds that are subsonic or supersonic. In one exemplary embodiment, a cleaning chemistry is delivered to the substrate through nozzles oriented almost parallel to the substrate. For example, the nozzles may be oriented no more than about 5° transverse to the substrate surface; no more than about 3° transverse to the substrate surface; or no more than about 1° transverse to the substrate surface.

Preferably, particles may be removed down to the detection limit of a scanning electron microscope of 8 nm and to the detection limits of a Surfscan at 50 ppb.

At present, prior art batch and single wafer processors use chemistry with volumes of water creating a significant waste stream and reclaim issue for recycling or discharging water. Vapor of the present invention may be produced using UNIT Delivery Systems chemistry (UDS) that delivers ready-to-use chemistry to the equipment in a clean interface container, and removes the output of the machine for convenient collection for reclaim as 50 to 100 times less reclaim volume than standard processor production. The successful integration of the two technologies permits a "bolt-on" final finish and dry unit that reduces both waste water and chemistries by two orders of magnitude, and increases the level of "soft-touch" contamination removal by over one order of magnitude.

The present invention may be applied to such fields as semiconductor manufacturing, nanotechnologies, medical sterilization technologies, MEMS, MOEMS, and many other processes.

A replacement of IPA with fugitive alcohols may facilitate the elimination of hydrocarbon contamination in the cleaning steps.

In an exemplary preferred embodiment, the present invention may be used in connection with wafers between about 150 mm and about 450 mm. In alternate embodiments, the present invention may be used for smaller wafer sizes such as those used in the hard disk industry in sizes of about 2.5 inches to about 3 inches.

In some embodiments of the present invention, other surface deposition techniques maybe used such as disclosed in U.S. Patent No. 6,817,385, the entire content of which is incorporated herein by reference thereto.

In some embodiments, the chemistries contemplated in the present invention may be dispensed from a cassette having up to 10 chemistries, and more preferably 5 to 10 chemistries, configured with valving that could either allow one chemistry or a mixture of several chemistries to occur just prior to injection into the chamber. Such mixing (instead of sequential injections of chemistries) may allow, for example, the mixing of a surfactant with a reactive chemistry for better surface contact and reactivity.

With the present invention, an expanded process window thus may be provided for cleaning a variety of residues encountered in the semiconductor industry. The expanded window includes chemistries and chemistry concentrations to promote release of residues and particles. In the preferred exemplary embodiment, the chemical concentrations and application time can be significantly reduced over prior art processes and more aggressive chemistries may be used for more precise process control. Vapor spray technology may permit very quick removal of gross particles and residues.

One concept for post-process drying involves sub-critical gas or liquid spray for waferscale processing. Another concept for post-process drying may involve an accelerated gas or liquid with an induced plasma. A near-dry process may be provided and may have residual, trace moisture as nanoclusters in the pattern or porosity.

To prevent residual water from being left on the surface in a single-wafer system, a positive-pressure chamber can be purged by turning off the chemistry for 4-7 seconds prior to wafer unload and increasing positive atmospheric flow in the chamber. However, doing so may fail to vacate trace moisture in porosity (dielectrics, etc.), and can actually impound the moisture. Instead, heated inert gas may be added to the expanding blended sub-critical gas flow, which reduces the positive atmospheric flow. The combination of sub-critical-gas accelerated plasma and thermal dynamic gas may dry without moisture expansion/explosion, which can cause delamination of wafer layers or water spots.

Inert gas is a gas that does not react substantially with the surface, such as helium, neon, argon, or nitrogen. For certain applications (i.e., where oxide formation is of no significance), purified atmosphere can be acceptable. The inert gas can be introduced at an elevated temperature, i.e., higher than ambient temperature. The elevated temperature can be, for example, between 50°C and 100 °C, between 70 °C and 90 °C, or about 80 °C. At this time, chemistry flow is maintained to evacuate heavy molecular contamination. The chemistry can include an oppositely charged chelator or surfactant running at between 0.1% and 1.0%, e.g., about 0.5%, to encourage removal of contaminants from porosity.

Advantageously, application areas for the cleaning technology of the present invention include:
1. Wet-to-Dry processes for gaining a more specific control of the chemical cleaning process and drying of a substrate, having particular importance to the Back-end-of-the-Line (BEOL) cleaning in the semiconductor industry;
2. the specific control of chemicals with the nano-clusters may be used in plating/coating processes, particularly in nanotechnology-related applications;
3. adjustments to the composition may provide a "drier" chemistry to further control the chemical consumption;
4. in some processes a gas/vapor spray may be used to remove particles less than about 50 nanometers along with the drying and curing of previously deposited films.

An expanded power level (process window) is possible for cleaning the newer, more difficult residues as discussed above. The expanded window includes chemistries and chemistry concentrations. Because the chemical concentrations and application time can be significantly reduced, more aggressive chemistries can be used for more precise process control. Thus, the end user can significantly reduce chemical consumption, utilize new chemistries, and significantly reduce if not eliminate certain final rinse and drying steps for submicron features on the substrate. Such features can be found for example in semiconductor devices (memory, logic, etc.), nanotechnologies, post chemical mechanical planarization (CMP) processes, and biotechnologies.

While various descriptions of the present invention are described above, it should be understood that the various features can be used singly or in any combination thereof. Therefore, this invention is not to be limited to only the specifically preferred embodiments depicted herein.

Further, it should be understood that variations and modifications within the scope of the invention may occur to those skilled in the art to which the invention pertains. For example, in each of the methods disclosed herein, the wet chemistries may be applied to substrates with techniques that that may include stirring, agitation, circulation, sonication, or other techniques as are known in the art. The methods disclosed herein may be applied to a variety of substrates including silicon and III-V semiconductors such as GaAs. Accordingly, all expedient modifications readily attainable by one versed in the art from the disclosure set forth herein that are within the scope of the present invention are to be included as further embodiments of the present invention. The scope of the present invention is accordingly defined as set forth in the appended claims.

## Claims

1. A method of cleaning submicron features on a semiconductor substrate comprising contacting a surface of the semiconductor substrate with a composition comprising an ionic liquid in neat or substantially pure form, wherein the ionic liquid comprises one or more cations and one or more anions.

2. The method of claim 1, wherein the ionic liquid includes a cation selected from the group consisting of an imidazolium cation, a pyridinium cation, a pyrrolidinium cation, an ammonium cation, and a phosphonium cation.

3. The method of claim 1, wherein the ionic liquid includes a cation having the formula: 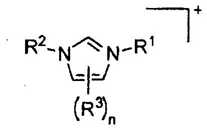 wherein R¹ is an optionally substituted C₁-C₂₀ alkyl, cycloalkyl, aralkyl, alkenyl, cycloalkenyl, or alkynyl group; R² is hydrogen or an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3.

4. The method of claim 1, wherein the ionic liquid includes a cation having the formula: 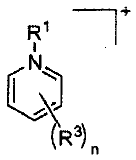 wherein R¹ is an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3.

5. The method of claim 1, wherein the ionic liquid includes a cation having the formula: 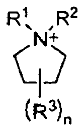 wherein R¹ and R², independently, are each an optionally substituted C₁-C₂₀ alkyl, cycloalkyl, aralkyl, alkenyl, cycloalkenyl, or alkynyl group; R³ is an optionally substituted C₁-C₁₂ alkyl, cycloalkyl, aralkyl, alkenyl, cycloalkenyl, or alkynyl group; and n is 0, 1, 2 or 3.

6. The method of claim 1, wherein the ionic liquid includes a cation having the formula: 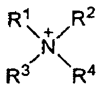 wherein R¹, R², R³, and R⁴, independently, are each an optionally substituted C₁-C₂₀ alkyl, cycloalkyl, aralkyl, alkenyl, cycloalkenyl, or alkynyl group.

7. The method of claim 1, wherein the ionic liquid includes a cation having the formula: 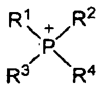 wherein R¹, R², R³, and R⁴, independently, are each an optionally substituted C₁-C₂₀ alkyl, cycloalkyl, aralkyl, alkenyl, cycloalkenyl, or alkynyl group.

8. The method of claim 1, wherein the ionic liquid includes a cation selected from the group consisting of a 1,3-dialkylimidazolium cation, a 1-alkylpyridinium cation, an N,N-dialkylpyrrolidinium cation, an tetraalkylammonium cation, and a tetraalkyl phosphonium cation.

9. The method of claim 1, wherein the ionic liquid includes a eutectic mixture.

10. The method of claim 9, wherein the eutectic mixture includes a quaternary ammonium salt and a hydrogen bonding partner.

11. The method of claim 10, wherein the quaternary ammonium salt includes a cation having the formula: 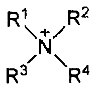 wherein R¹, R², R³, and R⁴, independently, are each an optionally substituted C₁-C₂₀ alkyl, cycloalkyl, aralkyl, alkenyl, cycloalkenyl, or alkynyl group.

12. The method of claim 11, wherein the quaternary ammonium salt includes a halide ion.

13. The method of claim 12, wherein the quaternary ammonium salt is choline chloride.

14. The method of claim 10, wherein the hydrogen bonding partner includes a carboxylic acid, an amide, or a urea.

15. The method of claim 10, wherein the hydrogen bonding partner includes a compound having the formula: 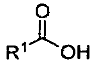 wherein R¹ is an optionally substituted C₁-C₂₀ alkyl, cycloalkyl, aralkyl, alkenyl, cycloalkenyl, or alkynyl group; or an optionally substituted C₁-C₁₀ aryl or heteroaryl group.

16. The method of claim 10, wherein the hydrogen bonding partner includes a compound having the formula: 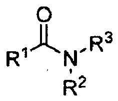 wherein R¹ is an optionally substituted C₁-C₂₀ alkyl, cycloalkyl, aralkyl, alkenyl, cycloalkenyl, or alkynyl, group; or an optionally substituted C₁-C₁₀ aryl or heteroaryl group; and R² and R³, independently, are each hydrogen or an optionally substituted C₁-C₂₀ alkyl, cycloalkyl, aralkyl, alkenyl, cycloalkenyl, or alkynyl group.

17. The method of claim 10, wherein the hydrogen bonding partner includes a compound having the formula: 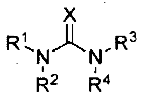 wherein X is O or S; and each of R¹, R², R³, and R⁴, independently, is an optionally substituted C₁-C₂₀ alkyl, cycloalkyl, aralkyl, alkenyl, cycloalkenyl, or alkynyl group; or an optionally substituted C₁-C₁₀ aryl or heteroaryl group.

18. The method of claim 1, wherein the surface is contacted with the composition for a period of time ranging from 30 seconds to 30 minutes.

19. The method of claim 1, wherein the surface is contacted with the composition for a period of time ranging from 30 seconds to 2 minutes.

20. The method of claim 1, wherein the surface is contacted with the composition for a period of time ranging from 2 minutes to 30 minutes.

21. The method of claim 1, wherein the surface is contacted with the composition at a temperature between 20°C and 70°C.

22. The method of claim 1, wherein the surface is contacted with the composition at a temperature between 20°C and 50°C.

23. The method of claim 1, wherein the surface is contacted with the composition at a temperature between 20°C and 35°C.

24. The method of claim 1, further comprising rinsing the semiconductor substrate with water after contacting the semiconductor substrate with the composition.

25. The method of claim 24, further comprising rinsing the semiconductor substrate with a solvent prior to rinsing the semiconductor substrate with water.

26. The method of claim 1, wherein the ionic liquid is discharged toward the semiconductor substrate through at least one nozzle oriented at an angle between about 0° and about 45° with respect to the surface.

27. The method of claim 1, wherein the ionic liquid is discharged toward the semiconductor substrate through at least one nozzle oriented at an angle between about 0° and about 25° with respect to the surface.

28. The method of claim 1, wherein the ionic liquid is discharged toward the semiconductor substrate through at least one nozzle oriented at an angle no more than about 5° transverse to the surface.

29. A semiconductor substrate cleaned according to the method of claim 1.

30. The semiconductor substrate of claim 29, wherein the semiconductor substrate is a wafer.

## Patentansprüche

1. Verfahren zur Reinigung von Submikron-Merkmalen auf einem Halbleitersubstrat, umfassend Inkontaktbringen einer Fläche des Halbleitersubstrats mit einer Zusammensetzung, die eine ionische Flüssigkeit in unverdünnter oder im Wesentlichen reiner Form umfasst, wobei die ionische Flüssigkeit ein oder mehrere Kationen und ein oder mehrere Anionen umfasst.

2. Verfahren nach Anspruch 1, wobei die ionische Flüssigkeit ein Kation beinhaltet, das ausgewählt ist aus der Gruppe, bestehend aus einem Imidazoliumkation, einem Pyridiniumkation, einem Pyrrolidiniumkation, einem Ammoniumkation und einem Phosphoniumkation.

3. Verfahren nach Anspruch 1, wobei die ionische Flüssigkeit ein Kation beinhaltet mit der Formel: 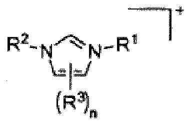 wobei R¹ eine wahlweise substituierte C₁-C₂₀ Alkyl-, Cycloalkyl-, Aralkyl-, Alkenyl-, Cycloalkenyl- oder Alkinylgruppe ist; R² Wasserstoff oder eine wahlweise substituierte C₁-C₂₀ Alkyl-, Cycloalkyl-, Aralkyl-, Alkenyl-, Cycloalkenyl- oder Alkinylgruppe ist; R³ eine wahlweise substituierte C₁-C₁₂ Alkyl-, Cycloalkyl-, Aralkyl-, Alkenyl-, Cycloalkenyl- oder Alkinylgruppe ist; und n 0, 1,2 oder 3 ist.

4. Verfahren nach Anspruch 1, wobei die ionische Flüssigkeit ein Kation beinhaltet mit der Formel: 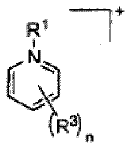 wobei R¹ eine wahlweise substituierte C₁-C₂₀ Alkyl-, Cycloalkyl-, Aralkyl-, Alkenyl-, Cycloalkenyl- oder Alkinylgruppe ist; R³ eine wahlweise substituierte C₁-C₁₂ Alkyl-, Cycloalkyl-, Aralkyl-, Alkenyl-, Cycloalkenyl- oder Alkinylgruppe ist; und n 0, 1, 2 oder 3 ist.

5. Verfahren nach Anspruch 1, wobei die ionische Flüssigkeit ein Kation beinhaltet mit der Formel: 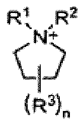 wobei R¹ und R², unabhängig, jeweils eine wahlweise substituierte C₁-C₂₀ Alkyl-, Cycloalkyl-, Aralkyl-, Alkenyl-, Cycloalkenyl- oder Alkinylgruppe sind; R³ eine wahlweise substituierte C₁-C₁₂ Alkyl-, Cycloalkyl-, Aralkyl-, Alkenyl-, Cycloalkenyl- oder Alkinylgruppe ist; und n 0, 1,2 oder 3 ist.

6. Verfahren nach Anspruch 1, wobei die ionische Flüssigkeit ein Kation beinhaltet mit der Formel: 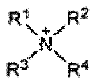 wobei R¹, R², R³ und R⁴, unabhängig, jeweils eine wahlweise substituierte C₁-C₂₀ Alkyl-, Cycloalkyl-, Aralkyl-, Alkenyl-, Cycloalkenyl- oder Alkinylgruppe sind.

7. Verfahren nach Anspruch 1, wobei die ionische Flüssigkeit ein Kation beinhaltet mit der Formel: 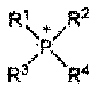 wobei R¹, R², R³ und R⁴, unabhängig, jeweils eine wahlweise substituierte C₁-C₂₀ Alkyl-, Cycloalkyl-, Aralkyl-, Alkenyl-, Cycloalkenyl- oder Alkinylgruppe sind.

8. Verfahren nach Anspruch 1, wobei die ionische Flüssigkeit ein Kation beinhaltet, das ausgewählt ist aus der Gruppe, bestehend aus einem 1,3-Dialkylimidazoliumkation, einem 1-Alkylpyridiniumkation, einem N,N-Dialkylpyrrolidiniumkation, einem Tetraalkylammoniumkation und einem Tetraalkylphosphoniumkation.

9. Verfahren nach Anspruch 1, wobei die ionische Flüssigkeit ein eutektisches Gemisch beinhaltet.

10. Verfahren nach Anspruch 9, wobei das eutektische Gemisch ein quartäres Ammoniumsalz und einen Wasserstoffbrückenbindungspartner beinhaltet.

11. Verfahren nach Anspruch 10, wobei das quartäre Ammoniumsalz ein Kation beinhaltet mit der Formel: 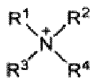 wobei R¹, R², R³ und R⁴, unabhängig, jeweils eine wahlweise substituierte C₁-C₂₀ Alkyl-, Cycloalkyl-, Aralkyl-, Alkenyl-, Cycloalkenyl- oder Alkinylgruppe sind.

12. Verfahren nach Anspruch 11, wobei das quartäre Ammoniumsalz ein Halogenidion beinhaltet.

13. Verfahren nach Anspruch 12, wobei das quartäre Ammoniumsalz Cholinchlorid ist.

14. Verfahren nach Anspruch 10, wobei der Wasserstoffbrückenbindungspartner eine Carbonsäure, ein Amid oder einen Harnstoff einschließt.

15. Verfahren nach Anspruch 10, wobei der Wasserstoffbrückenbindungspartner eine Verbindung einschließt mit der Formel: 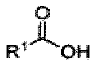 wobei R¹ eine wahlweise substituierte C₁-C₂₀ Alkyl-, Cycloalkyl-, Aralkyl-, Alkenyl-, Cycloalkenyl- oder Alkinylgruppe ist; oder eine wahlweise substituierte C₁-C₁₀ Aryl- oder Heteroarylgruppe ist.

16. Verfahren nach Anspruch 10, wobei der Wasserstoffbrückenbindungspartner eine Verbindung einschließt mit der Formel: 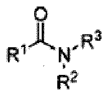 wobei R¹ eine wahlweise substituierte C₁-C₂₀ Alkyl-, Cycloalkyl-, Aralkyl-, Alkenyl-, Cycloalkenyl- oder Alkinylgruppe ist; oder eine wahlweise substituierte C₁-C₁₀ Aryl- oder Heteroarylgruppe ist; und R² und R³, unabhängig, jeweils Wasserstoff oder eine wahlweise substituierte C₁-C₂₀ Alkyl-, Cycloalkyl-, Aralkyl-, Alkenyl-, Cycloalkenyl- oder Alkinylgruppe sind.

17. Verfahren nach Anspruch 10, wobei der Wasserstoffbrückenbindungspartner eine Verbindung einschließt mit der Formel: 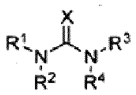 wobei X O oder S ist; und R¹, R², R³ und R⁴, unabhängig, jeweils eine wahlweise substituierte C₁-C₂₀ Alkyl-, Cycloalkyl-, Aralkyl-, Alkenyl-, Cycloalkenyl- oder Alkinylgruppe sind; oder eine wahlweise substituierte C₁-C₁₀ Aryl- oder Heteroarylgruppe sind.

18. Verfahren nach Anspruch 1, wobei die Fläche mit der Zusammensetzung für einen Zeitraum im Bereich von 30 Sekunden bis 30 Minuten in Kontakt gebracht wird.

19. Verfahren nach Anspruch 1, wobei die Fläche mit der Zusammensetzung für einen Zeitraum im Bereich von 30 Sekunden bis 2 Minuten in Kontakt gebracht wird.

20. Verfahren nach Anspruch 1, wobei die Fläche mit der Zusammensetzung für einen Zeitraum im Bereich von 2 Minuten bis 30 Minuten in Kontakt gebracht wird.

21. Verfahren nach Anspruch 1, wobei die Fläche mit der Zusammensetzung bei einer Temperatur zwischen 20 °C und 70 °C in Kontakt gebracht wird.

22. Verfahren nach Anspruch 1, wobei die Fläche mit der Zusammensetzung bei einer Temperatur zwischen 20 °C und 50 °C in Kontakt gebracht wird.

23. Verfahren nach Anspruch 1, wobei die Fläche mit der Zusammensetzung bei einer Temperatur zwischen 20 °C und 35 °C in Kontakt gebracht wird.

24. Verfahren nach Anspruch 1, das weiterhin Spülen des Halbleitersubstrats mit Wasser nach Inkontaktbringen des Halbleitersubstrats mit der Zusammensetzung umfasst.

25. Verfahren nach Anspruch 24, das weiterhin Spülen des Halbleitersubstrats mit einem Lösungsmittel vor Spülen des Halbleitersubstrats mit Wasser umfasst.

26. Verfahren nach Anspruch 1, wobei die ionische Flüssigkeit zum Halbleitersubstrat hin durch zumindest eine Düse abgegeben wird, die in einem Winkel zwischen etwa 0° und etwa 45° bezogen auf die Fläche ausgerichtet ist.

27. Verfahren nach Anspruch 1, wobei die ionische Flüssigkeit zum Halbleitersubstrat hin durch zumindest eine Düse abgegeben wird, die in einem Winkel zwischen etwa 0° und etwa 25° bezogen auf die Fläche ausgerichtet ist.

28. Verfahren nach Anspruch 1, wobei die ionische Flüssigkeit zum Halbleitersubstrat hin durch zumindest eine Düse abgegeben wird, die in einem Winkel von nicht mehr als etwa 5° schräg zur Fläche ausgerichtet ist.

29. Gemäß dem Verfahren des Anspruchs 1 gereinigtes Halbleitersubstrat.

30. Halbleitersubstrat nach Anspruch 29, wobei das Halbleitersubstrat ein Wafer ist.

## Revendications

1. Procédé de nettoyage de plots submicroniques sur un substrat semi-conducteur, comprenant la mise en contact d'une surface du substrat semi-conducteur avec une composition comprenant un liquide ionique sous forme pure ou essentiellement pure, dans lequel le liquide ionique comprend un ou plusieurs cations et un ou plusieurs anions.

2. Procédé selon la revendication 1, dans lequel le liquide ionique inclut un cation choisi dans le groupe constitué par un cation imidazolium, un cation pyridinium, un cation pyrrolidinium, un cation ammonium et un cation phosphonium.

3. Procédé selon la revendication 1, dans lequel le liquide ionique inclut un cation ayant la formule: 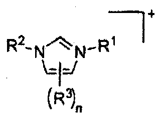 dans laquelle R¹ est un groupe en C₁-C₂₀ alkyle, cycloalkyle, aralkyle, alcényle, cycloalcényle ou alcynyle facultativement substitué; R² est hydrogène ou un groupe en C₁-C₂₀ alkyle, cycloalkyle, aralkyle, alcényle, cycloalcényle ou alcynyle facultativement substitué; R³ est un groupe en C₁-C₁₂ alkyle, cycloalkyle, aralkyle, alcényle, cycloalcényle ou alcynyle facultativement substitué; et n est 0, 1, 2 ou 3.

4. Procédé selon la revendication 1, dans lequel le liquide ionique inclut un cation ayant la formule: 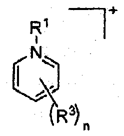 dans laquelle R¹ est un groupe en C₁-C₂₀ alkyle, cycloalkyle, aralkyle, alcényle, cycloalcényle ou alcynyle facultativement substitué; R³ est un groupe en C₁-C₁₂ alkyle, cycloalkyle, aralkyle, alcényle, cycloalcényle ou alcynyle facultativement substitué; et n est 0, 1, 2 ou 3.

5. Procédé selon la revendication 1, dans lequel le liquide ionique inclut un cation ayant la formule: 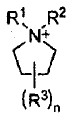 dans laquelle R¹ et R², indépendamment, sont chacun un groupe en C₁-C₂₀ alkyle, cycloalkyle, aralkyle, alcényle, cycloalcényle ou alcynyle facultativement substitué; R³ est un groupe en C₁-C₁₂ alkyle, cycloalkyle, aralkyle, alcényle, cycloalcényle ou alcynyle facultativement substitué; et n est 0, 1,2 ou 3.

6. Procédé selon la revendication 1, dans lequel le liquide ionique inclut un cation ayant la formule: 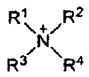 dans laquelle R¹, R², R³ et R⁴, indépendamment, sont chacun un groupe en C₁-C₂₀ alkyle, cycloalkyle, aralkyle, alcényle, cycloalcényle ou alcynyle facultativement substitué.

7. Procédé selon la revendication 1, dans lequel le liquide ionique inclut un cation ayant la formule: 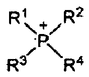 dans laquelle R¹, R², R³ et R⁴, indépendamment, sont chacun un groupe en C₁-C₂₀ alkyle, cycloalkyle, aralkyle, alcényle, cycloalcényle ou alcynyle facultativement substitué.

8. Procédé selon la revendication 1, dans lequel le liquide ionique inclut un cation choisi dans le groupe constitué par un cation 1,3-dialkylimidazolium, un cation 1-alkylpyridinium, un cation N,N-dialkylpyrrolidinium, un cation tétraalkylammonium et un cation tétraalkyl phosphonium.

9. Procédé selon la revendication 1, dans lequel le liquide ionique inclut un mélange eutectique.

10. Procédé selon la revendication 9, dans lequel le mélange eutectique inclut un sel d'ammonium quaternaire et un partenaire de liaison hydrogène.

11. Procédé selon la revendication 10, dans lequel le sel d'ammonium quaternaire inclut un cation ayant la formule: 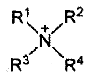 dans laquelle R¹, R², R³ et R⁴, indépendamment, sont chacun un groupe en C₁-C₂₀ alkyle, cycloalkyle, aralkyle, alcényle, cycloalcényle ou alcynyle facultativement substitué.

12. Procédé selon la revendication 11, dans lequel le sel d'ammonium quaternaire inclut un ion halogénure.

13. Procédé selon la revendication 12, dans lequel le sel d'ammonium quaternaire est un chlorure de choline.

14. Procédé selon la revendication 10, dans lequel le partenaire de liaison hydrogène inclut un acide carboxylique, un amide ou une urée.

15. Procédé selon la revendication 10, dans lequel le partenaire de liaison hydrogène inclut un composé ayant la formule: 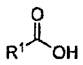 dans laquelle R¹ est un groupe en C₁-C₂₀ alkyle, cycloalkyle, aralkyle, alcényle, cycloalcényle ou alcynyle facultativement substitué; ou un groupe en C₁-C₁₀ aryle ou hétéroaryle facultativement substitué.

16. Procédé selon la revendication 10, dans lequel le partenaire de liaison hydrogène inclut un composé ayant la formule: 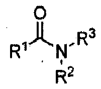 dans laquelle R¹ est un groupe en C₁-C₂₀ alkyle, cycloalkyle, aralkyle, alcényle, cycloalcényle ou alcynyle facultativement substitué; ou un groupe en C₁-C₁₀ aryle ou hétéroaryle facultativement substitué; et R² et R³, indépendamment, sont chacun hydrogène ou un groupe en C₁-C₂₀ alkyle, cycloalkyle, aralkyle, alcényle, cycloalcényle ou alcynyle facultativement substitué.

17. Procédé selon la revendication 10, dans lequel le partenaire de liaison hydrogène inclut un composé ayant la formule: 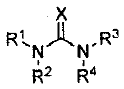 dans laquelle X est O ou S; et chacun parmi R¹, R², R³ et R⁴, indépendamment, est un groupe en C₁-C₂₀ alkyle, cycloalkyle, aralkyle, alcényle, cycloalcényle ou alcynyle facultativement substitué; ou un groupe en C₁-C₁₀ aryle ou hétéroaryle facultativement substitué.

18. Procédé selon la revendication 1, dans lequel la surface est mise en contact avec la composition pendant une période de temps allant de 30 secondes à 30 minutes.

19. Procédé selon la revendication 1, dans lequel la surface est mise en contact avec la composition pendant une période de temps allant de 30 secondes à 2 minutes.

20. Procédé selon la revendication 1, dans lequel la surface est mise en contact avec la composition pendant une période de temps allant de 2 minutes à 30 minutes.

21. Procédé selon la revendication 1, dans lequel la surface est mise en contact avec la composition à une température entre 20°C et 70°C.

22. Procédé selon la revendication 1, dans lequel la surface est mise en contact avec la composition à une température entre 20°C et 50°C.

23. Procédé selon la revendication 1, dans lequel la surface est mise en contact avec la composition à une température entre 20°C et 35°C.

24. Procédé selon la revendication 1, comprenant en outre le rinçage du substrat semi-conducteur avec de l'eau après la mise en contact du substrat semi-conducteur avec la composition.

25. Procédé selon la revendication 24, comprenant en outre le rinçage du substrat semi-conducteur avec un solvant avant de rincer le substrat semi-conducteur avec de l'eau.

26. Procédé selon la revendication 1, dans lequel le liquide ionique est véhiculé vers le substrat semi-conducteur à travers au moins une buse orientée à un angle entre environ 0° et environ 45° par rapport à la surface.

27. Procédé selon la revendication 1, dans lequel le liquide ionique est véhiculé vers le substrat semi-conducteur à travers au moins une buse orientée à un angle entre environ 0° et environ 25° par rapport à la surface.

28. Procédé selon la revendication 1, dans lequel le liquide ionique est véhiculé vers le substrat semi-conducteur à travers au moins une buse orientée à un angle non supérieur à environ 5° transversalement par rapport à la surface.

29. Substrat semi-conducteur nettoyé selon le procédé selon la revendication 1.

30. Substrat semi-conducteur selon la revendication 29, lequel substrat semi-conducteur est une tranche.
